# EUROPÄISCHE PATENTSCHRIFT

(11) **EP 3 385 731 B1**
(45) Veröffentlichungstag und Bekanntmachung des Hinweises auf die Patenterteilung: **05.08.2020**
(21) Anmeldenummer: 18151113.0
(22) Anmeldetag: 11.01.2018
(51) Int. Cl.: G01R 31/50

(54) **MESSVORRICHTUNG FÜR ERDFEHLERSTRÖME**
MEASURING DEVICE FOR GROUND FAULT CURRENTS
DISPOSITIF DE MESURE DE COURANT DE FUITE À LA TERRE

(30) Priorität: 30.03.2017 DE 102017106814
(43) Veröffentlichungstag der Anmeldung: 10.10.2018
(73) Patentinhaber: innogy SE, 45128 Essen (DE); Westnetz GmbH, 44139 Dortmund (DE)
(72) Erfinder: Fischer, Andreas, 54316 Hockweiler (DE); Grommes, Alex, 54329 Konz (DE); Stüber, Peter Fabian, 54317 Morscheid (DE); Moos, Thomas, 53293 Trier (DE); Müllenbach, Hans-Peter, 54516 Flußbach (DE)
(74) Vertreter: Cohausz & Florack

(56) Entgegenhaltungen:
- US-A- 4 546 309
- US-A1- 2013 063 842
- US-A1- 2016 349 305
- US-A1- 2017 016 947

## Beschreibung

Der Gegenstand betrifft eine Messvorrichtung sowie ein Verfahren zum Betreiben einer Messvorrichtung zum Messen von Erdschlussrestströmen bzw.

### Erdfehlerströmen

Das Betriebsverhalten eines Energieversorgungsnetzes wird beim Auftritt eines einpoligen Fehlers mit Erdberührung im Wesentlichen von der Art der Sternpunktbehandlung bestimmt, mit der es betrieben wird. In Netzen mit isoliertem Sternpunkt oder Erdschlusskompensation wird die Höhe der Erdschlussströme im Wesentlichen durch die kapazitiven Eigenschaften der Leiter bestimmt. Die Erdschlusskompensation, d.h. die Beschaltung des Transformatorsternpunkts mit einer auf die Leiter-Erd-Kapazität abgestimmten Petersen-Spule (E-Spule), stellt bislang ein wirksames Mittel zur Begrenzung der Erdschlussströme dar.

Da der kapazitive Erdfehlerstrom von Betriebsspannung, Frequenz und Leiter-Erd-Kapazitäten abhängt, steigt mit fortschreitendem Netzausbau die erforderliche Kompensationsleistung Der Erdschlussreststrom in kompensiert betriebenen Netzen wird vom kapazitiven Erdfehlerstrom, dem Verstimmungsgrad (Einstellung der E-Spule), dem Dämpfungsgrad (Wirkstromanteile), Einkopplungen von ggf. parallel geführten Systemen und höherharmonischen Erdfehlerstromanteilen bestimmt. Die höherharmonischen Anteile im stationären Erdfehlerstrom sind abhängig von der Oberschwingungsbelastung, sowie von der Verteilung der Kapazitäten und Induktivitäten im Netz (Resonanzen). Insbesondere vor dem Hintergrund der Einhaltung der zulässigen Berührungsspannung nach DIN VDE 0101 gilt es, die Erdfehlerströme auf ein zulässiges Maß zu begrenzen.

Mit Hilfe von Berechnungen werden die Grenzen des Ausbaus gelöschter Netze bestimmt. Bei diesen Berechnungen wird zunehmend auch der Einfluss von Oberschwingungen und deren Resonanzen berücksichtigt, um bei weiterem Netzausbau oder Netztrennungen (Schalthandlungen) die Überschreitung des max. zulässigen Erdfehlerstroms zu vermeiden, da diese Höherharmonischen nicht von der E-Spule kompensiert werden.

Mit Hilfe von komplexeren Berechnungsmethoden werden nicht nur die Kapazitätsbelege der Leitungen berücksichtigt, sondern weitere Betriebsparameter und Netzkenngrößen, um die stationären Erdfehlerströme inklusive ihrer Oberschwingungsanteile berechnen zu können. Hierbei werden insbesondere Oberschwingungsanteile der Erdfehlerströme der ersten, dritten, fünften, siebten und/oder elften Ordnung sowie ggf. höherer harmonischen Ordnungen, insbesondere ungeradzahlige Harmonische, insbesondere solche bis zur 19. Ordnung berücksichtigt. Die Berechnungen zeigen, dass aufgrund der Oberschwingungsbelastung die zu erwartenden Erdfehlerströme bei bestimmten Netzkonstellationen deutlich höher ausfallen können.

Das Berechnungsmodell, welches zur Bestimmung der Erdfehlerströme verwendet werden soll, berücksichtigt somit auch die höherharmonischen Erdfehlerströme. Eine Validierung des Berechnungsansatzes war bisher jedoch nicht möglich, da hierzu mittels Erdschlussversuchen die Erdfehlerströme in einem Versorgungsnetz zu messen wären. Herkömmliche Erdschlussversuche sind jedoch aufwendig und mit dem Risiko einer Versorgungsunterbrechung verbunden. Doch ist die Kenntnis der tatsächlich auftretenden Erdfehlerströme entscheidend für die Einhaltung der zulässigen Berührungsspannungen im Fehlerfall und somit für die Gewährleistung der Personensicherheit.

Die US 2013/0063842 A1 offenbart einen Leck Detektor, der mit einer Ausgangssteuerschaltung versehen ist, die eine Schaltungs-Draht-Erde-Spannung überwacht.
Die US 2016/0349305 A1 beschreibt ein automatisiertes Erdschlussprüfsystem und ein Frühwarnsystem zur Echtzeitüberwachung der Erdungswerte.

Die US 2017/0016947 A1 offenbart eine Vorrichtung und ein Verfahren zum Erfassen eines Leck Stroms, der entlang eines Primärleiters auftritt. Dabei wird ein erstes Fehlererfassungsmodul an einem ersten Ort entlang des Primärleiters eingesetzt, und ein zweites Treibermodul wird an einem zweiten Ort entlang des Leiters eingesetzt.

Die US 4,546,309 beschreibt eine Vorrichtung zum Lokalisieren von Erdfehlern in Gleichstromsteuersystemen, umfassend einen Niederfrequenz-Stromgenerator mit variablem Ausgang.

Dem Gegenstand lag die Aufgabe zugrunde, Erdfehlerströme besonders präzise und sicher hinsichtlich der Personen- und Versorgungssicherheit erfassen zu können.

Diese Aufgabe wird durch eine Messvorrichtung nach Anspruch 1 sowie ein Verfahren nach Anspruch 7 gelöst.

Es ist erkannt worden, dass Erdfehlerströme in weit verteilten Versorgungsnetzen häufig ortsveränderlich sind. Um die Erdfehlerströme für das gesamte Verteilnetz oder bestimmte Stränge abschätzen zu können, ist es daher notwendig, an ausgewählten Punkten innerhalb des Verteilnetzes Erdfehlerströme messen zu können. Mit Hilfe der mobilen Messvorrichtung gemäß Anspruch 1 ist diese ortsveränderliche Messung der Erdfehlerströme in einem Versorgungsnetz möglich. Wenn vorliegend von Versorgungsnetz die Rede ist, so ist vorzugsweise von einem Mittelspannungsnetz mit einer Spannung von 1kV bis zu 36kV die Rede.

Die Messvorrichtung verfügt über ein Schutzgerät. Ein Schutzgerät kann dabei analog oder digital, mit oder ohne Steuerfunktion ausgestattet sein. Insbesondere ein Schutzgerät kann zum Einsatz kommen, Ein Schutzgerät dient zur Netzüberwachung, sowie ggf. zur Steuerung von Leistungsschutzschaltern und Schaltgeräten sowie ggf. zur Automatisierung von Schaltgeräten. Schutzgeräte können beispielsweise einen Überstromschutz gemäß UMZ oder AMZ nach ANSI 50 oder ANSI 51 realisieren.

Neben dem Schutzgerät sind in der Messvorrichtung ein Lasttrennschalter sowie ein Leistungsschalter vorgesehen, die jeweils mit dem Schutzgerät gekoppelt sein können. Der Schaltzustand des Lasttrennschalters (der vorzugsweise manuell geschaltet wird) lässt sich über einen Sensor erfassen und an das Schutzgerät übermitteln. Somit kann das Schutzgerät den Schaltzustand des Lasttrennschalters überwachen. Über das Schutzgerät lässt sich der Leistungsschalter schalten. Der Leistungsschalter ist vorzugsweise motorisch betrieben.

Der Lasttrennschalter befindet sich bevorzugt in einem Kabelfeld und wird insbesondere manuell betätigt. Der Lasttrennschalter ist bevorzugt einem Messfeld und einem Leistungsschalterfeld vorgeschaltet. Der Lasttrennschalter wird benötigt um während der Montage und Demontage der Trossenleitungen an der Freileitung, mittels einem AuS-Arbeitsverfahren, einen definierten Schaltzustand der Messvorrichtung herbeizuführen und so die Sicherheit des Arbeitsverfahrens zu gewährleisten.

Nach erfolgter Installation der Trossenleitungen wird der Lasttrennschalter manuell eingeschaltet, so dass die Spannung der Trossenleitungen bis zum Messfeld ansteht. Vor der Demontage wird über den Lasttrennschalter das Messfeld von der Spannung der Trossenleitung wieder getrennt.

Eine Kopplung zwischen dem Lasttrennschalter und dem Leistungsschalter erfolgt bevorzugt über Meldekontakte. Der Leistungsschalter kann vorzugsweise nur dann eingeschaltet werden, wenn der Lasttrennschalter sich im geschlossenen Zustand befindet. Der Leistungsschalter dient der Einleitung und Abschaltung des Erdschlusses während der eigentlichen Messung.

Darüber hinaus ist in der Messvorrichtung eine Messeinrichtung vorgesehen, mit deren Hilfe Netzparameter erfasst werden können. Hierbei können beispielsweise einzelne oder mehrere Parameter der folgenden Normen erfasst und ausgewertet werden EN 50160 (2013), IEC 61000-2-2 , IEC 61000-2-12, IEC 61000-2-4, NRS 04, IEEE 519, IEC 61000-4-30, IEC 6:1000-4-7, IEC 61000-4-15. Aufzeichnungsintervalle können beispielsweise 200 Millisekunden, 1 Sekunde, 3Sekunde, 2 Minuten, 5 Minuten, 10 Minuten oder 2 Stunden sein. Vorliegend ist für die Messung des Erdfehlerstroms ein Aufzeichnungsintervall von bis zu einer Sekunde ausreichend. Die oben genannten Parameter können ganz oder teilweise auch mit einem PQ Analyzer erfasst werden.

Mit Hilfe der Messeinrichtung können Leiterspannungen (Leiter-Erd-Spannungen) einzelner, mehrerer, insbesondere aller Phasen erfasst werden. Auch können Oberschwingungsanteile (Gesamtverzerrungsfaktor THD-U) im Normalzustand und nach eingeleitetem Erdschluss einzelner, mehrerer, insbesondere aller Phasen erfasst werden. Auch kann der Fehlerstrom der geerdeten Phase, insbesondere inkl. Oberschwingungsanteile (THD-I) und/oder deren Erdungsspannung, erfasst werden.

Die Messvorrichtung selbst ist mit einem Betriebserder geerdet. Zur Gewährleistung der Personensicherheit wird ein zusätzlicher Versuchserder eingesetzt. Der Versuchserder kann räumlich von der Messvorrichtung entfernt errichtet sein. Der Versuchserder kann abgeschrankt sein. Zwischen Betriebs- und Versuchserder kann während des Erdschlussversuchs die Erdungsspannung gemessen werden. Schließlich wird die Messvorrichtung mit einer Trossenleitung an jeweils eine Phase des Versorgungsnetzes, insbesondere eine Freileitung des Versorgungsnetzes angeschlossen.

Um nun mobil ortsveränderlich Erdfehlerströme bzw. andere Netzparameter zur Bestimmung der Ströme erfassen zu können, ist vorgeschlagen, dass die Messvorrichtung auf einem mobilen Gestell montiert ist. Das Gestell ist vorzugsweise ein PKW-Anhänger mit Ausmaßen von maximal 3m Breite, 4m Länge und 4m Höhe. Das Gestell ist vorzugsweise einachsig radgelagert und kann über eine Deichsel zur Kopplung mit einer Anhängerkupplung verfügen. Auch kann das Gestell zweiachsig oder mehrachsig sein.

Durch die Mobilität der Messvorrichtung kann diese an die geeignete Stelle innerhalb des Versorgungsnetzes transportiert werden, beispielsweise unmittelbar unterhalb einer zu messende Leitung. Anschließend können unter Berücksichtigung der Vorschriften "Arbeiten unter Spannung (AuS)" die Anschlussleitungen mit jeweils einer Phase des Versorgungsnetzes, insbesondere des Mittelspannungsnetzes verbunden werden.

In die Messvorrichtung sind die Anschlussleitungen isoliert hereingeführt und werden in die Mittelspannungsschaltanlage geführt. Die Schaltanlage kann dabei mehrere gegeneinander störlichtbogengesicherte Felder aufweisen. Insbesondere können jeweils zumindest ein Kabelaufnahmefeld, optional zumindest ein Kabelaufführungsfeld, zumindest ein Messfeld und/oder zumindest ein Leistungsschalterfeld vorgesehen sein. Die Schaltanlage kann in modularer Einzelfeldbauweise ausgeführt sein. Die Schaltanlage kann gasisoliert, insbesondere SF6 isoliert sein.

Das Kabelfeld dient der Aufnahme der Anschlussleitung. In dem Kabelfeld können der Lasttrennschalter und/oder ein Erdungsschalter untergebracht sein. Die Schalter ermöglichen es, während des Anschlusses der Trossenleitungen beim Arbeitsverfahren unter Spannung einen definierten Schaltzustand herzustellen und somit ein sicheres Arbeiten zu gewährleisten.

Im Messfeld sind insbesondere eine Messeinrichtung und sekundärtechnische Komponenten untergebracht. Insbesondere können Wandler zur Erfassung der Spannungen und Ströme im Messfeld untergebracht sein. Hierbei können Breitbandmesswandler mit erweitertem Frequenzbereich oder ohmsch-kapazitive Spannungssensoren zum Einsatz kommen. Mit Hilfe der Messeinrichtung lassen sich insbesondere über Wandler Spannungen und Ströme messen. Auch ist eine direkte Messung weiterer Messgrößen mit einem PQ Analyzer, der im Messfeld angeordnet sein kann, möglich.

Der Leistungsschalter kann im Leistungsschalterfeld untergebracht sein. Über ihn wird für die Dauer des Messintervalls ein zumindest einpoliger Erdschluss eingelegt und wieder abgeschaltet.

Zwischen den einzelnen Feldern können Sammelschienen geführt werden, über die die einzelnen Phasen von den Anschlussleitungen über den Lasttrennschalter, die Messeinrichtung und den Leistungsschutzschalter geführt sind.

Zusätzlich kann das Schutzgerät und die weiteren sekundärtechnischen Komponenten in einem zusätzlichen Steuerungsschrank oder im Messfeld angeordnet sein. Zu den weiteren Komponenten können Sicherungsautomaten, Stromversorgung, USV und/oder ein PQ Analyzer gehören.

Die Schaltschränke bzw. Felder sind nebeneinander auf dem Gestell montiert. Die Schaltschränke bzw. Felder können gegeneinander störlichtbogensicher ausgeführt sein.

Das Gestell und vorzugsweise auch die Schaltschränke sind vorzugsweise über einen Betriebserder geerdet. Somit ist es möglich, mit Hilfe der Messvorrichtung wahlweise zumindest eine Anschlussleitung und somit zumindest eine Phase des Versorgungsnetzes auf den Versuchserder zu legen und somit einen Erdungsfehler zu erzeugen.

Durch das kurzzeitige Erzeugen eines Erdschlusses in kompensierten Mittelspannungsnetzen ist es möglich, zumindest die relevanten Ströme und Spannungen zu messen und so Rückschlüsse auf das Netzverhalten im Erdfehlerfall ziehen zu können.

Die Anschlussleitungen sind vorzugsweise Trossenleitungen, die in einem Freileitungsabschnitt des Mittelspannungsnetzes angeschlossen werden können.

Das Schutzgerät kann drahtlos angesteuert werden. Das Schutzgerät kann den Leistungsschalter ansteuern. Wird dieser geschlossen, kann ein Erdschluss an zumindest jeweils einer Phase bewirkt werden und die oben genannten Messungen können durchgeführt werden. In Erdschlussfall kann für die geerdete Phase mit Hilfe der Messeinrichtung zumindest der Erdfehlerstrom als auch die Erdungsspannung zwischen dem Versuchserder und dem Betriebserder gemessen werden. Durch die drahtlose Ansteuerung des Schutzgerätes ist ein risikofreier Einsatz der Messvorrichtung im Mittelspannungsnetz möglich. Der Messvorgang kann drahtlos gestartet werden. Anschließend erfolgt der Messvorgang automatisch, insbesondere wird der Leistungsschalter geschlossen und geöffnet und die Messung mit Hilfe der Messeinrichtung durchgeführt. Der ausführende Mitarbeiter kann sich somit außerhalb eines vorschriftsmäßig abgesperrten Umfelds von der Messeinrichtung und des Versuchserders aufhalten.

Wie bereits erläutert, kann mit Hilfe der Messeinrichtung eine Erdungsspannung zwischen dem Versuchserder und dem Betriebserder gemessen werden.

Der Versuchserder wird vorzugsweise in einer ausreichenden Entfernung zu dem Betriebserder errichtet. Hierzu ist der Versuchserder über eine Anschlussleitung mit der Messvorrichtung verbunden.

Bei dem gegenständlichen Verfahren wird zumindest eine der Anschlussleitungen mit zumindest einem Leiterseil einer Freileitung eines in Betrieb befindlichen elektrischen Versorgungsnetzes verbunden. Dies erfolgt unter Anwendung der Arbeitsmethode "Arbeiten unter Spannung (AuS)" mittels einem entsprechenden AuS-Arbeitsverfahren. Bei dieser Verbindung muss das Mittelspannungsnetz nicht freigeschaltet werden, so dass keine Versorgungsunterbrechung im Netzbetrieb erfolgt.

Nachdem der Versuchserder montiert wurde und die Messanordnung ausreichend abgesichert wurde, kann aus einem sicheren Abstand ferngesteuert das Schutzgerät angesteuert werden. Das Schutzgerät schaltet den Leistungsschalter und schließt somit die Verbindung zwischen der Freileitung und dem Versuchserder.

Dieser Erdschluss ruft den zu erfassenden Erdfehlerstrom hervor. Nach einer kurzen Zeit, beispielsweise nach 300 Millisekunden, ist der Erdfehlerstrom eingeschwungen und mit Hilfe der Messeinrichtung können die elektrischen Parameter erfasst werden. Insbesondere wird der Erdfehlerstrom (bzw. der Erdschlussreststrom) sowie die Erdungsspannung gemessen. Nach dieser kurzzeitigen Messung wird automatisiert über das Schutzgerät der Erdschluss aufgetrennt und somit der Erdfehlerstrom unterbrochen. Hierzu kann das Schutzgerät den Leistungsschalter öffnen.

Die gesamte Messung dauert vorzugsweise weniger als 5 Sekunden, insbesondere weniger als 1 Sekunde. Um einen eingeschwungenen Zustand messen zu können, ist der Erdschluss jedoch vorzugsweise länger als 300 Millisekunden.

Es wird vorzugsweise an nur einer der Phasen zumindest die beschriebene Messung durchgeführt um die Erdfehlerrestströme an dieser Phase bestimmen zu können. Es ist auch möglich, zwei oder mehr, insbesondere alle Phasen zu vermessen. Dies ist jedoch nicht immer sinnvoll und kann zu einigem Mehraufwand führen. In der Regel ist die Messung an nur einer Phase ausreichend.

Durch den kurzen Erdschluss, der im Netzbetrieb ebenfalls häufiger auftritt und als sogenannter "Wischer" bezeichnet wird, ist die Stabilität des Netzbetriebes nicht beeinflusst. Das Risiko einer Versorgungsunterbrechung, ausgelöst durch einen Folgefehler, kann durch die kurzen Messzeiten erheblich reduziert werden. Darüber hinaus ist die Auswahl der Netzabschnitte, in denen die Messung durchgeführt wird, derart, dass diese als stabil gegenüber Erdschlusswischern gelten. Dies lässt sich statistisch auswerten, in dem die Netzstabilität bei Erdschlusswischern ausgewertet wird.

Um höherfrequente Anteile des Erdfehlerstroms als auch der Erdungsspannung auswerten zu können, erfolgt die Messung der elektrischen Parameter vorzugsweise mit einer Abtastrate von zumindest 1 kHz, vorzugsweise 2kHz, insbesondere 2,5kHz und vorzugsweise bis zu 50kHz.

Vor der eigentlichen Messung des Erdfehlerstroms wird zunächst die Spannung an zumindest einer der Freileitungen gemessen, um den Zustand des Versorgungsnetzes ohne Erdungsfehler bestimmen zu können.

Bevorzugt werden die elektrischen Parameter an einer Freileitung gemessen, so dass der Erdfehlerstrom und die Erdspannung auf dieser Phase bekannt sind. Auch ist es möglich, den Erdschluss an einer Phase zu erzeugen, und zusätzlich weitere elektrische Parameter an den anderen Phasen zu messen. Auch kann der Erdschluss sukzessive an verschiedenen Phasen samt Messung durchgeführt werden.

Durch das beschriebene Messverfahren lassen sich Aussagen über die tatsächlichen Erdfehlerströme und Erdungsspannungen treffen. Mit Hilfe dieser Aussagen lässt sich die Einhaltung der Berührungsspannung im Fehlerfall und die Dimensionierung der Erdungsanlagen überprüfen.

Mit Hilfe der Kenntnis über die Erdspannung und den Erdfehlerstrom kann eine bessere Aussage über die Kompensation des Netzes getroffen werden. Dadurch kann z.B. der Berührschutz an Erdungsanlagen an die tatsächlichen Bedingungen im Netz im Erdschlussfall angepasst werden. Auch kann es möglich sein, eine Kompensation der höherharmonischen Schwingungen mit aktiver Leistungselektronik durchzuführen, so dass das Netz besser kompensiert ist.

Nachfolgend wird der Gegenstand anhand einer Ausführungsbeispiele zeigenden Zeichnung näher erläutert.
- Fig. 1: zeigt ein vereinfachtes, dem Berechnungsmodell zugrunde liegende Ersatzschaltbild
- Fig. 2: zeigt eine mobile Messvorrichtung;
- Fig. 3: zeigt den Ablauf des gegenständlichen Messverfahrens.

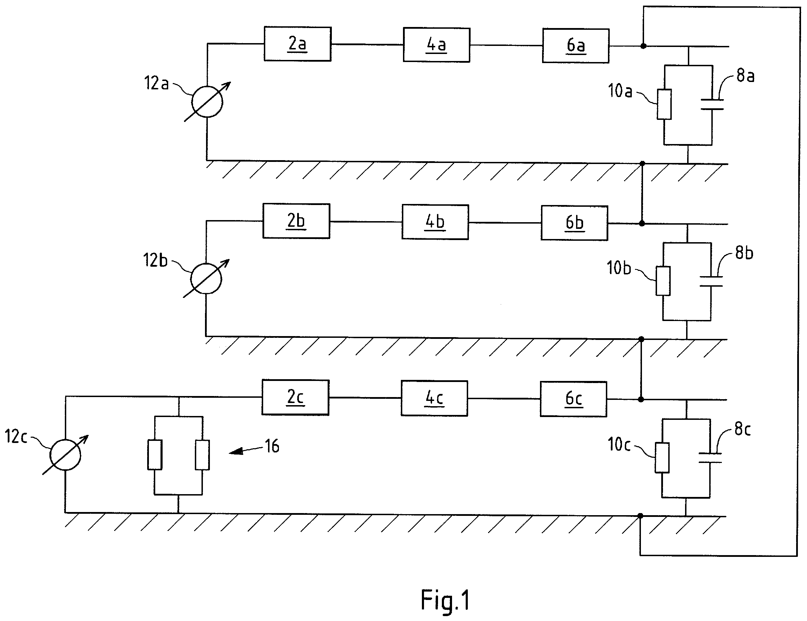

Fig. 1 zeigt ein vereinfachtes Ersatzschaltbild unter Annahme symmetrischer Komponenten im Erdschluss. Gezeigt sind die Trafoinduktivitäten 2a, b, c, die Leitungsinduktivitäten 4a, b, c sowie die Leitungswiderstände 6a, b, c, die Leitungskapazitäten 8a, b, c sowie die Widerstände des Restnetzes 10a, b, c. An jeder Phase lässt sich eine Kurzschlussspannung 12a, b, c messen. Ein Kurzschlussstrom 14 ist ebenfalls messbar. Schließlich ist in dem Ersatzschaltbild der Fig. 1 die Petersenspule 16, welche zur Erdschlusskompensation eingesetzt ist, gezeigt. Anhand dieses Ersatzschaltbildes lassen sich die Erdfehlerrestströme 14 berechnen und mit Hilfe der gegenständlichen Messvorrichtung und des gegenständlichen Messverfahrens diese Berechnung verifizieren.

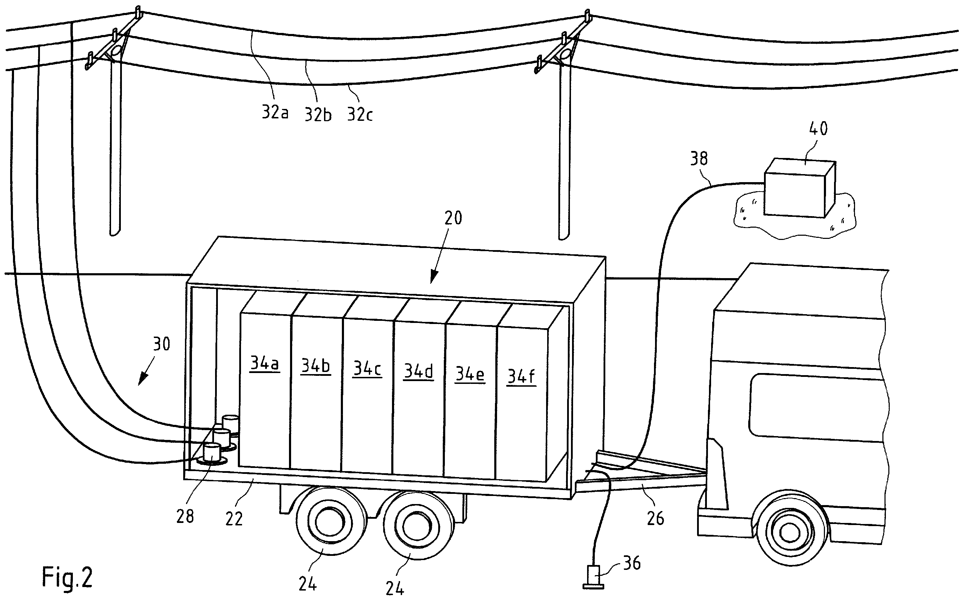

Fig. 2 zeigt eine gegenständliche Messvorrichtung 20 mit einem Gestell 22, welches mobil auf Rädern 24 gelagert ist. Über eine Deichsel 26 lässt sich das Gestell 22 mit einem Fahrzeug verbinden.

Auf dem Gestell 22 sind Anschlusskonsolen 28 für Trossenleitungen 30 vorgesehen. Die Trossleitungen 30 können unter Anwendung eines AuS-Arbeitsverfahrens an jeweils einer Phase 32a, b, c eines Mittelspannungsnetzes angeschlossen werden.

Auf dem Gestell 22 sind nebeneinander die Einzelfelder der Mittelspannungsschaltanlage und der Steuerschrank installiert. Die Felder sind gegeneinander elektrisch gesichert. Durch die Felder werden die Phasen entlang einer Sammelschiene geführt.

Die Leitungen 30 können zunächst in ein Kabelfeld 34a geführt werden. Ausgehend von dem Kabelfeld 34a werden die einzelnen Phasen in ein Kabelaufführungsfeld 34b geführt und von dort an das Messfeld 34c geleitet. Das Kabelaufführungsfeld 34b kann entfallen, wenn die Kabelführung in den anderen Feldern in einer gleichen Ebene erfolgt und somit keine Kabelaufführung notwendig ist.

Ausgehend von dem Messfeld 34c werden die Phasen an das Kabelaufführungsfeld 34d und von dort an das Leistungsschalterfeld 34e geführt. Schließlich ist ein Steuerschrank 34f vorgesehen, in dem ein Schutzgerät und weitere sekundärtechnischen Komponenten installiert sein können.

In dem Messfeld 34d kann eine Messeinrichtung zur Messung der benötigten elektrischen Größen, insbesondere der Leiter-Erd-Spannungen inkl. Oberschwingungsanteilen (THD-U) an den einzelnen Phasen sowie des Erdfehlerstroms inkl. Oberschwingungsanteilen (THD-I) vorgesehen sein. Die Leiter-Erd-Spannung kann außerhalb des Messfeldes gemessen werden. Die einzelnen Felder sind vorzugsweise metallische Schaltschränke, die geerdet auf dem Gestell 22 über einen Betriebserder 36 angeschlossen sind. Ferner kann ausgehend von dem Leistungsschalterfeld, an dem Ausgang eines Leistungsschalters ein Anschlusskabel 38 geführt werden, an das ein Versuchserder 40 angeschlossen sein kann. Der Versuchserder 40 kann mit einer der Phasen 32a, b, c verbunden werden, indem ein Leistungsschalter auf eine Sammelschiene, welche mit der Leitung 38 verbunden ist, gelegt wird. Vorzugsweise wird nur ein Leistungsschalter vorgesehen, und somit erfolgt ein Erdschluss über den Leistungsschalter nur für eine Phase.

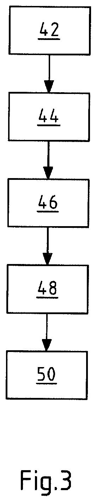

Der Ablauf des Verfahrens ist in Fig. 3 dargestellt.

Für die Messung wird zunächst die Messvorrichtung 20 an eine geeignete Stelle des Versorgungsnetzes bewegt und dort aufgebaut (42).

Anschließend (44) kann der Versuchserder 40 als auch der Betriebserder 36 installiert werden.

Danach werden die Erdungsimpedanzen erfasst (46) und überprüft.

Anschließend wird der Versuchserder 40 abgeschrankt (48).

Um im Anschluss die Phasen 32a, b, c (von den Freileitungen) an die Messvorrichtung anzuschließen, werden die Lasttrennschalter manuell geöffnet (50). Der Schaltzustand der Lasttrennschalter wird vorzugsweise über Sensoren erfasst und ausgewertet. Der Schaltzustand wird vorzugsweise an ein Schutzgerät übermittelt und dort für das Schalten des Leistungsschalters verwendet.

Ist der Lasttrennschalter geöffnet, erfolgt, unter Anwendung eines AuS-Arbeitsverfahrens, die Verbindung der Trossenleitungen 30 mit den Phasen 32a-c (52). In diesem Zustand sind die Leistungsschalter und Lasttrennschalter alle geöffnet. Die Trossenleitungen 30 sind isoliert in das Kabelfeld 34a auf die jeweiligen Lasttrennschalter geführt.

Nun können die Lasttrennschalter mittels AuS Verfahren geschlossen werden (54) und die Anlage ist betriebsbereit. Die Netzspannung steht bis in das Messfeld an.

Aus einer ausreichend großen Entfernung wird nun ferngesteuert (56) das Schutzgerät in dem Steuerungsschrank 34f angesteuert.

Zunächst wird eine Analyse des Netzzustands im ungestörten Zustand durchgeführt. Hierzu wird die Netzspannung an jeder Phase mit der Messeinrichtung ermittelt. Hierbei kann eine dreiphasige THD (U) Analyse (58) durchgeführt werden.

Das Schutzgerät überwacht den Zustand des Lasttrennschalters und wenn dieser geschlossen ist und die Initialisierung der Messung über den Funkkbefehl erfolgt, schließt es die Schaltkontakte des Leistungsschalters und somit eine der Phasen 32a-c mit dem Versuchserder 40 kurz. Dadurch wird ein einphasiger Erdschluss provoziert (60). Dieser Schaltvorgang wird für eine Phase durchgeführt und dauert weniger als eine Sekunde.

Während einem Intervall von ca. 300 Millisekunden wird durch die Messeinrichtung in dem Messfeld die relevante elektrische Größe gemessen (62). Hierbei werden insbesondere transiente Elemente gemessen, in dem eine hohe Abtastrate von beispielsweise über 1kHz realisiert wird. Der Erdfehlerstrom kann mit einer THD(I) Analyse erfasst werden. Außerdem kann die Erdspannung zwischen dem Betriebserder und dem Versuchserder erfasst werden.

Im Anschluss (64) wird der Leistungsschalter wieder geöffnet und somit der Erdschluss beendet.

Die von der Messeinrichtung und dem PQ Analyzer erfassten Messwerte werden ausgelesen (66).

Danach werden die Lasttrennschalter manuell geöffnet (68) um die Messvorrichtung freizuschalten.

Abschließend werden die Trossenleitungen 30 mittels AuS Verfahren von den Freileitungen demontiert (70) und Betriebs- und Versuchserder werden demontiert (72).

Die Schritte (58) - (64) können ferngesteuert ausgelöst werden und werden dann automatisiert durchgeführt.

### Bezugszeichenliste

- 2: Trafoinduktivität
- 4: Leitungsinduktivität
- 6: Leitungswiderstand
- 8: Leitungskapazität
- 10: Widerstand
- 12: Kurzschlussspannung
- 14: Kurzschlussstrom
- 16: Petersenspule
- 20: Messvorrichtung
- 22: Gestell
- 24: Räder
- 26: Deixel
- 28: Anschlusskonsole
- 30: Trossenleitung
- 32: Phase
- 34: Schaltschrank
- 36: Betriebserder
- 38: Anschlussleitung
- 40: Versuchserder

## Patentansprüche

1. Messvorrichtung (20) umfassend
- ein Schutzgerät,
- zumindest einen Lasttrennschalter,
- zumindest einen mit dem Schutzgerät gekoppelten Leistungsschalter,
- eine Messeinrichtung eingerichtet zur Erfassung von Netzparametern,
- zumindest einen Versuchserder (40),
- zumindest einen Betriebserder (36),
- zumindest eine mit dem Lasttrennschalter verbundene Anschlussleitung (30) eingerichtet zum Anschluss an eine Phase (32) des Versorgungsnetzes, und zumindest eine mit dem Leistungsschalter verbundene Anschlussleitung (38) an dem Versuchserder (40), wobei
- die Messvorrichtung (20) auf einem mobilen Gestell (22) montiert ist,
**dadurch gekennzeichnet,**
- **dass** die Anschlussleitung (30) in ein gekapseltes Kabelfeld geführt ist, in dem vorzugsweise der Lasttrennschalter angeordnet ist und/oder
- **dass** die Messeinrichtung in einem gekapselten Messfeld angeordnet ist und/oder
- **dass** der Leistungsschalter in einem gekapselten Leistungsschalterfeld angeordnet sind und/oder
- **dass** das Schutzgerät in einem gekapselten Steuerungsschrank angeordnet ist, und/oder
- **dass** das Kabelfeld, das Messfeld, das Leistungsschalterfeld und der Steuerschrank gemeinsam auf dem Gestell (22) montiert sind.

2. Messvorrichtung (20) nach Anspruch 1,
**dadurch gekennzeichnet,**
**dass** zumindest drei Anschlussleitungen (30) für den Anschluss an jeweils eine Phase (32) eines Mittelspannungsnetzes vorgesehen sind und oder dass jeweils eine Phase (32) mit einem jeweiligen Lasttrennschalter verbunden ist.

3. Messvorrichtung (20) nach Anspruch 1 oder 2,
**dadurch gekennzeichnet,**
**dass** die Anschlussleitung (30) mit einer Reihenschaltung aus Lasttrennschalter, Leistungsschalter, Messeinrichtung und Versuchserder (40) oder Betriebserder (36) verbunden ist.

4. Messvorrichtung (20) nach einem der vorangehenden Ansprüche,
**dadurch gekennzeichnet,**
**dass** das Schutzgerät drahtlos ansteuerbar ist, insbesondere zur Ansteuerung des Leistungsschalters.

5. Messvorrichtung (20) nach einem der vorangehenden Ansprüche,
**dadurch gekennzeichnet,**
- **dass** die Messeinrichtung zur Messung einer Spannung zwischen dem Versuchserder (40) und dem Betriebserder (36) eingerichtet ist.

6. Messvorrichtung (20) nach einem der vorangehenden Ansprüche,
**dadurch gekennzeichnet,**
**dass** der Versuchserder (40) über die Anschlussleitung (38) entfernt von dem mobilen Gestell (22) installierbar ist.

7. Verfahren zum Betreiben einer Messvorrichtung (20) nach einem der vorangegangenen Ansprüche, bei dem
- zumindest eine Anschlussleitung (30) mit zumindest einer Freileitung eines elektrischen Versorgungsnetzes verbunden wird,
- ferngesteuert über das Schutzgerät der Leistungsschalter geschlossen wird, so dass die Freileitung über die Messvorrichtung (20) mit dem Versuchserder (40) oder dem Betriebserder (36) kurzgeschlossen wird,
- während des Kurzschlusses durch die Messeinrichtung elektrische Parameter erfasst werden und
- anschließend automatisiert über das Schutzgerät der Leistungsschalter geöffnet wird.

8. Verfahren nach Anspruch 7,
**dadurch gekennzeichnet,**
- **dass** der Erdschluss für weniger als 5 Sekunden, vorzugsweise weniger als 1 Sekunde geschaltet wird und/oder dass der Erdschluss für zumindest 300 Millisekunden geschaltet wird.

9. Verfahren nach Anspruch 7 oder 8,
**dadurch gekennzeichnet,**
- **dass** die elektrischen Parameter mit einer Abtastrate von zumindest 1 kHz und bis zu 50 kHz abgetastet werden.

10. Verfahren nach einem der vorangehenden Ansprüche,
**dadurch gekennzeichnet,**
- **dass** vor dem Erdschluss zumindest die Spannung an der zumindest einer, vorzugsweise allen drei Phasen (32) der Freileitung gemessen wird.

11. Verfahren nach einem der vorangehenden Ansprüche,
**dadurch gekennzeichnet,**
- **dass** die elektrischen Parameter an allen Freileitungen gemessen werden.

## Claims

1. Measuring device (20) comprising
- a protection device,
- at least one switch disconnector,
- at least one circuit breaker coupled to the protection device,
- a measuring device arranged for aquiring network parameters,
- at least one test earth electrode (40),
- at least one operational earth electrode (36),
- at least one connection line (30) connected to the switch-disconnector and arranged for connecting with a phase (32) of the supply network, and
- at least one connecting line (38) connecting the circuit breaker to the test earth electrode (40), wherein
- the measuring device (20) is mounted on a mobile frame (22),
**characterized in that,**
- the connecting line (30) is led into an encapsulated cable field in which the switch disconnector is preferably arranged and/or
- the measuring device is arranged in an encapsulated measuring field and/or
- the circuit breaker is arranged in an encapsulated circuit breaker panel and/or
- the protection device is arranged in an encapsulated control cabinet, and/or
- the cable field, the measuring field, the circuit breaker field and the control cabinet are mounted together on the frame (22).

2. Measuring device (20) according to claim 1,
**characterized in that,**
at least three connecting lines (30) are provided for connection to a respective phase (32) of a medium-voltage network, and or **in that** a respective phase (32) is connected to a respective load-break switch.

3. Measuring device (20) according to claim 1 or 2,
**characterized in that,**
the connecting line (38) is connected in series with a series connection of load-break switches, circuit breaker, measuring device and test earth electrode (40) or operational earth electrode (36).

4. Measuring device (20) according to one of the preceding claims,
**characterized in that,**
the protection device is controllable wirelessly, in particular for controlling the circuit breaker.

5. Measuring device (20) according to one of the preceding claims,
**characterized in that,**
the measuring device is set up to measure a voltage between the test earth electrode (40) and the operational earth electrode (36).

6. Measuring device (20) according to one of the preceding claims,
**characterized in that,**
the test earth electrode (40) can be installed remotely from the mobile frame (22) via the connecting line (38).

7. Method for operating a measuring device (20) according to one of the preceeding claims, in which
- at least one connecting line (30) is connected to at least one overhead line of an electrical supply network,
- the circuit breaker is closed remotely controlled via the protection device so that the overhead line is short-circuited with the test earth electrode (40) or the operating earth electrode (36) via the measuring device (20),
- electrical parameters are recorded by the measuring device during the short circuit and
- then the circuit-breaker will automatically be opened via the protection device.

8. Method according to claim 7,
**characterized in that,**
- the earth fault is switched for less than 5 seconds, preferably less than 1 second and/or that the earth fault is switched for at least 300 milliseconds.

9. Method according to claim 7 or 8,
**characterized in that,**
- the electrical parameters are measured with a sampling rate of at least 1 kHz up to 50 kHz.

10. Method according to any of the preceding claims,
**characterized in that,**
- before the earth fault at least the voltage at the at least one, preferably all three phases (32) of the overhead line is measured.

11. Method according to one of the preceding claims,
**characterized in that,**
- the electrical parameters are measured on all overhead lines.

## Revendications

1. Dispositif de mesure (20) comprenant :
- un appareil de protection,
- au moins un sectionneur à coupure en charge,
- au moins un sectionneur de puissance couplé à l'appareil de protection,
- un appareil de mesure configuré pour la détection de paramètres de réseau,
- au moins une prise de terre d'essai (40),
- au moins une prise de terre de service (36),
- au moins une ligne de raccordement (30) reliée au sectionneur à coupure en charge, ladite ligne de raccordement étant configurée pour le raccordement à une phase (32) du réseau de distribution, et comprenant au moins une ligne de raccordement (38) à la prise de terre d'essai (40), ladite ligne de raccordement étant reliée au sectionneur de puissance, où
- le dispositif de mesure (20) est monté sur un plateau support mobile (22),
**caractérisé**
- **en ce que** la lignes de raccordement (30) est guidées dans une cellule de câbles blindée, cellule de câbles dans laquelle est disposé de préférence le sectionneur à coupure en charge et/ou
- **en ce que** l'appareil de mesure est disposé dans une cellule de mesure blindée et/ou
- **en ce que** les sectionneurs de puissance sont disposés dans une cellule de sectionneurs de puissance blindée et/ou
- **en ce que** l'appareil de protection est disposé dans un coffret de commande blindé, et/ou
- **en ce que** la cellule de câbles, la cellule de mesure, la cellule de sectionneurs de puissance et le coffret de commande sont montés ensemble sur le plateau support (22).

2. Dispositif de mesure (20) selon la revendication 1,
**caractérisé**
- **en ce qu'**il est prévu au moins trois lignes de raccordement (30) à chaque fois pour le raccordement à une phase (32) d'un réseau moyenne tension et ou en ce qu'une phase (32) est à chaque fois reliée à un sectionneur à coupure en charge respectif.

3. Dispositif de mesure (20) selon la revendication 1 ou 2,
**caractérisé**
- **en ce que** la ligne de raccordement (30) est reliée à un circuit en série se composant d'un sectionneur à coupure en charge, d'un sectionneur de puissance, d'un appareil de mesure et d'une prise de terre d'essai (40) ou d'une prise de terre de service (36).

4. Dispositif de mesure (20) selon l'une quelconque des revendications précédentes,
**caractérisé**
- **en ce que** l'appareil de protection peut être commandé sans fil, en particulier pour la commande du sectionneur de puissance.

5. Dispositif de mesure (20) selon l'une quelconque des revendications précédentes,
**caractérisé**
- **en ce que** l'appareil de mesure est configuré pour la mesure d'une tension entre la prise de terre d'essai (40) et la prise de terre de service (36).

6. Dispositif de mesure (20) selon l'une quelconque des revendications précédentes,
**caractérisé**
- **en ce que** la prise de terre d'essai (40) peut être installée en étant à distance du plateau support mobile (22), via la ligne de raccordement (38).

7. Procédé permettant de faire fonctionner un dispositif de mesure (20) selon l'une quelconque des revendications précédentes, procédé dans lequel
- au moins une ligne de raccordement (30) est reliée à au moins une ligne aérienne d'un réseau de distribution électrique,
- le sectionneur de puissance est fermé par l'appareil de protection commandé à distance, de sorte que la ligne aérienne est court-circuitée avec la prise de terre d'essai (40) ou avec la prise de terre de service (36), via le dispositif de mesure (20),
- pendant le court-circuit, des paramètres électriques sont détectés par l'appareil de mesure, et
- ensuite, le sectionneur de puissance est ouvert par l'appareil de protection, de façon automatisée.

8. Procédé selon la revendication 7,
**caractérisé**
- **en ce que** la mise à la terre est effectuée pour moins de 5 secondes, de préférence pour moins de 1 seconde et/ou en ce que la mise à la terre est effectuée pour au moins 300 millisecondes.

9. Procédé selon la revendication 7 ou 8,
**caractérisé**
- **en ce que** les paramètres électriques sont échantillonnés à une fréquence d'échantillonnage au moins de 1 kHz et allant jusqu'à 50 kHz.

10. Procédé selon l'une quelconque des revendications précédentes,
**caractérisé**
- **en ce que**, avant la mise à la terre, au moins la tension au moins de l'une des phases, de préférence la tension de la totalité des trois phases (32), est mesurée dans la ligne aérienne.

11. Procédé selon l'une quelconque des revendications précédentes,
**caractérisé**
- **en ce que** les paramètres électriques sont mesurés sur toutes les lignes aériennes.
